# FASCICULE DE BREVET EUROPEEN

(11) **EP 2 670 700 B1**
(45) Date de publication et mention de la délivrance du brevet: **20.08.2014**
(21) Numéro de dépôt: 12700040.4
(22) Date de dépôt: 05.01.2012
(51) Int. Cl.: B81C 99/00

(54) **Méthode de fabrication d'une pièce de micromécanique complexe et à faible rugosité**
Verfahren zur Herstellung eines komplexen glatten mikromechanischen Teils
Method for producing a complex smooth micromechanical part

(30) Priorité: 03.02.2011 EP 11153243
(43) Date de publication de la demande: 11.12.2013
(73) Titulaire: Nivarox-FAR S.A., 2400 Le Locle (CH)
(72) Inventeur: CUSIN, Pierre, CH-1423 Villars-Burquin (CH); RICHARD, David, CH-1400 Yverdon-les-Bains (CH); DUBOIS, Philippe, CH-2074 Marin (CH)
(74) Mandataire: Couillard, Yann Luc Raymond
(86) Numéro de dépôt international: PCT/EP2012/050127
(87) Numéro de publication internationale: WO 2012/104110

(56) Documents cités:
- EP-A1- 2 236 455
- US-A- 6 015 599
- US-A1- 2003 111 759
- KARCZEMSKA A ET AL: "Diamond Microfluidic Devices manufactured with the replica method", PERSPECTIVE TECHNOLOGIES AND METHODS IN MEMS DESIGN, 2009. MEMSTECH 2009. 2009 5TH INTERNATIONAL CONFERENCE ON, IEEE, PISCATAWAY, NJ, USA, 22 avril 2009 (2009-04-22), pages 17-19, XP031471595, ISBN: 978-966-2191-06-6
- PRASAD S V ET AL: "Application of Diamond-Like Nanocomposite Tribological Coatings on LIGA Microsystem Parts", JOURNAL OF MICROELECTROMECHANICAL SYSTEMS, IEEE SERVICE CENTER, PISCATAWAY, NJ, US, vol. 18, no. 3, 1 juin 2009 (2009-06-01), pages 695-704, XP011254803, ISSN: 1057-7157

## Description

### Domaine de l'invention

L'invention se rapporte à une pièce de micromécanique complexe fabriquée à partir d'un matériau quelconque comme par exemple à base de carbone ainsi qu'à un procédé de fabrication d'une telle pièce.

### Arrière-plan de l'invention

La fabrication de pièce de micromécanique uniquement en diamant synthétique ou en DLC (abréviation provenant des termes anglais « Diamond Like Carbon ») est très chère et n'est pas tribologiquement favorable à cause de la rugosité défavorable générée par le processus de dépôt en couche épaisse ou par un procédé de gravage dans la masse. Par conséquent, actuellement, on pratique plutôt le revêtement de pièce de micromécanique à l'aide de diamant synthétique ou de DLC en fine couche sans toutefois pouvoir obtenir n'importe quelle forme.

L'article de KARCZEMSKA A ET AL: "Diamond Microfluidic Devices manufactured with the replica method", PERSPECTIVE TECHNOLOGIES AND METHODS IN MEMS DESIGN, 2009. MEMSTECH 2009. 2009 5TH INTERNATIONAL CONFERENCE ON, IEEE, PISCATAWAY, NJ, USA, 22 avril 2009 (2009-04-22), pages 17-19, décrit un procédé de fabrication d'une pièce de micromécanique en un matériau monobloc à base d'un allotrope synthétique du carbone, comportant les étapes a) former un substrat comportant l'empreinte négative de ladite pièce de micromécanique à fabriquer; b) recouvrir ladite empreinte négative du substrat directement d'une couche dudit matériau à base d'un allotrope synthétique du carbone; et d) retirer le substrat afin de laisser libre la pièce de micromécanique monobloc formée dans ladite empreinte négative. Dans le but de produire une pièce massive, lors de l'étape b) la couche remplit totalement les creux formés entre les empreintes des micro-canaux et réservoirs

### Résumé de l'invention

Le but de la présente invention est de pallier tout ou partie les inconvénients cités précédemment en proposant une pièce de micromécanique de géométrie complexe utilisant une quantité minimale de matériau dont la rugosité est très améliorée permettant un taux et un coût de rebut très favorables.

A cet effet, l'invention se rapporte à un procédé de fabrication d'une pièce de micromécanique en un matériau monobloc à base d'un allotrope synthétique du carbone caractérisé en ce qu'il comporte les étapes suivantes :
a) former un substrat comportant l'empreinte négative de ladite pièce de micromécanique à fabriquer ;
b) recouvrir ladite empreinte négative du substrat directement d'une couche dudit matériau à base d'un allotrope synthétique du carbone d'une épaisseur inférieure à la profondeur de ladite empreinte ;
c) retirer du substrat une épaisseur supérieure à celle de la couche déposée afin de laisser une épaisseur de ladite couche circonscrite dans ladite empreinte négative ;
d) retirer le substrat afin de laisser libre la pièce de micromécanique monobloc formée dans ladite empreinte négative et comportant une surface externe de rugosité comparable à celle du substrat

On comprend donc que le procédé autorise la fabrication d'une pièce de micromécanique monobloc, c'est-à-dire sans discontinuité de matière, qui comporte une « peau » de matériau, c'est-à-dire peu de matériau, dont la surface externe reprend la rugosité très favorable du substrat ce qui permet de diminuer très sensiblement le coût du matériau voulu sur la couche externe et d'améliorer la rugosité globale, surtout au niveau de la surface externe, pour parfaire sa tribologie.

Conformément à d'autres caractéristiques avantageuses de l'invention :
- l'empreinte négative comporte une paroi formant une denture ;
- le procédé comporte, entre l'étape b) et l'étape c), l'étape e) : remplir l'empreinte revêtue du premier matériau à base d'un allotrope synthétique du carbone avec un deuxième matériau afin qu'après les étapes c) et d), on obtienne une pièce de micromécanique en un premier matériau à base d'un allotrope synthétique du carbone renforcé et/ou décoré par un deuxième matériau ;
- le procédé comporte, entre l'étape c) et l'étape d), l'étape f) : remplir l'empreinte revêtue du premier matériau à base d'un allotrope synthétique du carbone avec un deuxième matériau afin qu'après l'étape d), on obtienne une pièce de micromécanique en un premier matériau à base d'un allotrope synthétique du carbone renforcé et/ou décoré par un deuxième matériau ;
- lors de l'étape f), le deuxième matériau est formé en saillie de ladite empreinte afin de former un élément fonctionnel supplémentaire à la pièce de micromécanique ;
- le deuxième matériau comporte un métal ou un alliage métallique ;
- la pièce de micromécanique forme une partie de l'habillage, un spiral, un balancier, une ancre, un pont, un mobile ou une roue d'échappement d'une pièce d'horlogerie.

De plus, l'invention se rapporte à une pièce de micromécanique creuse obtenue à partir du procédé selon l'une des revendications précédentes, ladite pièce étant formée de manière monobloc en matériau à base d'un allotrope synthétique du carbone selon une couche d'épaisseur comprise entre 0,2 µm et 20 µm, ladite pièce comportant une surface externe dont la hauteur est supérieure à l'épaisseur de la couche en matériau à base d'un allotrope synthétique du carbone, ladite surface externe comportant une hauteur comprise entre 10 µm et 500 µm et dont la rugosité comprend un écart moyen arithmétique sensiblement inférieur à 10 nm.

Conformément à d'autres caractéristiques avantageuses de l'invention :
- ladite surface externe forme une denture ;
- le creux de la pièce en matériau à base d'un allotrope synthétique du carbone est au moins partiellement rempli avec un deuxième matériau afin d'obtenir une pièce de micromécanique à base d'un allotrope synthétique du carbone renforcé et/ou décoré par un deuxième matériau ;
- ledit deuxième matériau est formé en saillie de ladite hauteur de la surface externe afin de former un élément fonctionnel supplémentaire à la pièce de micromécanique l'empreinte négative comporte une paroi formant une denture ;
- le deuxième matériau comporte un métal ou un alliage métallique.

Enfin, l'invention se rapporte à une pièce d'horlogerie caractérisée en ce qu'elle comporte une pièce de micromécanique selon l'une des variantes précédentes, ladite pièce de micromécanique pouvant former tout ou partie de l'habillage, d'un spiral, d'un balancier, d'une ancre, d'un pont, d'un mobile ou d'une roue d'échappement.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations d'étapes successives d'un procédé de fabrication selon un premier mode de réalisation de l'invention ;
- les figures 6 à 10 sont des représentations d'exemples de pièces de micromécaniques obtenues selon un premier mode de réalisation de l'invention ;
- les figures 11 à 13 sont des représentations d'étapes successives d'un procédé de fabrication selon un deuxième mode de réalisation de l'invention ;
- la figure 14 est une représentation d'un exemple de pièce de micromécanique obtenue selon un deuxième mode de réalisation de l'invention ;
- les figures 15 et 16 sont des représentations d'étapes successives d'un procédé de fabrication selon un troisième mode de réalisation de l'invention ;
- la figure 17 est une représentation d'un exemple de pièce de micromécanique obtenue selon un troisième mode de réalisation de l'invention.

### Description détaillée des modes de réalisation préférés

Comme expliqué ci-dessus, l'invention se rapporte d'abord à une pièce de micromécanique monobloc par exemple en un matériau à base de carbone. A base de carbone signifie un allotrope synthétique du carbone sous forme cristalline, comme du diamant ou une ou plusieurs couches de graphène, ou sous forme amorphe, comme du DLC (abréviation provenant des termes anglais « Diamond Like Carbon »).

Bien entendu, avantageusement selon l'invention, d'autres types de matériaux, qui sont déposables sous forme de couche et qui présentent un intérêt tribologique, peuvent être utilisés alternativement à un allotrope synthétique du carbone. Un tel matériau alternatif peut, par exemple, être un composé à base de silicium, c'est-à-dire par exemple du nitrure de silicium, de l'oxyde de silicium ou du carbure de silicium.

Cette pièce de micromécanique a été imaginée pour des applications dans le domaine horloger. Toutefois, d'autres domaines peuvent parfaitement être imaginés comme notamment l'aéronautique, la bijouterie ou l'automobile.

Dans le domaine horloger, cette pièce de micromécanique peut, à titre d'exemple, former une partie de l'habillage, le spiral, le balancier, l'ancre, les ponts ou même les mobiles comme les roues d'échappement totalement ou partiellement à base d'un allotrope synthétique du carbone ou d'un matériau alternatif comme expliqué ci-dessus.

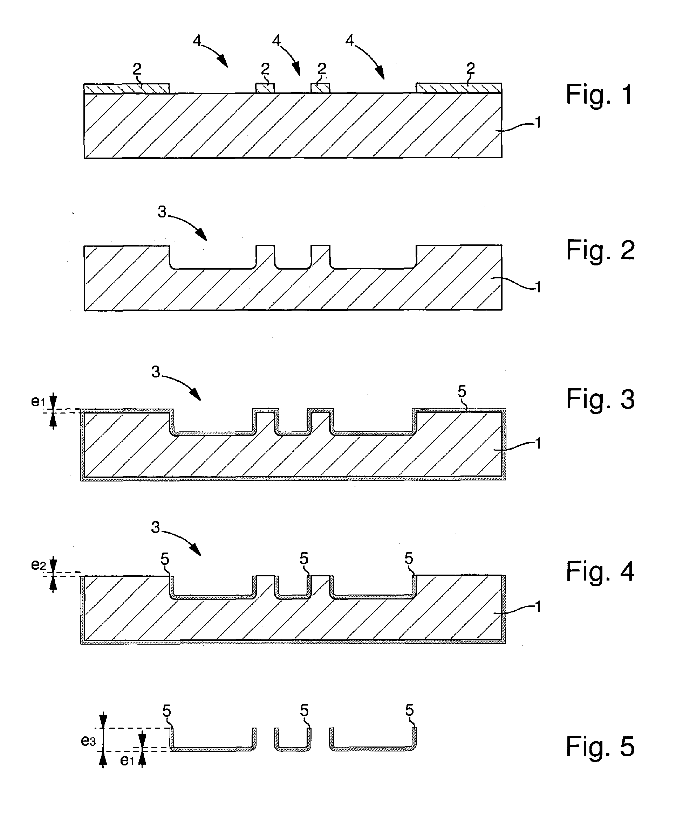

Un premier mode de réalisation d'un procédé de fabrication d'une telle pièce de micromécanique est présenté aux figures 1 à 5. Dans une étape a, le procédé consiste à former, dans un substrat 1, une empreinte 3 négative de la future pièce de micromécanique 11, 21, 31, 41. Une grande variété de substrats 1 est possible. Préférentiellement, la matière du substrat 1 est choisie pour sa très faible rugosité, c'est-à-dire son caractère naturel à présenter une surface lisse.

A titre d'exemple, les figures 1 et 2 présentent l'étape a formée à partir d'un substrat 1 en silicium pour lequel il est possible d'obtenir une très bonne rugosité, c'est-à-dire un écart moyen arithmétique Rₐ sensiblement inférieur à 10 nm. Ainsi, dans une première phase illustrée à la figure 1, le substrat 1 est revêtu d'un masque 2 présentant des ajourages 4 laissant non recouverte une partie supérieure du substrat 1. Dans une deuxième phase, un gravage selon les ajourages 4 est effectué. Un tel gravage peut être réalisé par une attaque sèche ou humide. Enfin, dans une troisième phase illustrée à la figure 2, le masque 2 est retiré pour ne laisser que l'empreinte 3 négative réalisée dans le substrat 1.

Une deuxième étape b consiste à recouvrir au moins l'empreinte négative 3 par une couche 5 d'épaisseur e₁ du matériau souhaité pour la future pièce de micromécanique. Dans l'exemple illustré à la figure 3, le substrat 1 est entièrement revêtue d'une couche 5, c'est-à-dire au moins dans l'empreinte 3 gravée lors de l'étape a. Comme pour le matériau déposé, le type de dépôt peut être très varié. A titre non limitatif, l'étape b peut comporter un dépôt chimique en phase vapeur, un dépôt physique en phase vapeur ou un dépôt par galvanoplastie.

Dans une troisième étape c, le procédé consiste à retirer une partie du substrat 1 revêtu de la couche 5 afin de laisser une épaisseur de ladite couche 5 circonscrite dans ladite empreinte négative 3. Préférentiellement selon l'invention, on enlève une épaisseur e₂ du substrat 1 supérieure à celle e₁ de la couche 5 comme illustré à la figure 4. On comprend donc que la couche 5 présente dans l'empreinte 3 du substrat 1 est désormais indépendante, c'est-à-dire non jointive, par rapport au reste de la couche 5 déposée lors de l'étape b.

Dans une quatrième et dernière étape d du premier mode de réalisation, le procédé consiste à retirer le substrat 1 afin de libérer la pièce de micromécanique formée dans l'empreinte 3. Par conséquent, dans l'exemple ci-dessus dans lequel le substrat 1 est en silicium, l'étape d peut consister en une attaque sélective du silicium. Cela peut, par exemple, être obtenu par une attaque chimique au moyen d'un bain comportant de l'hydroxyde de tétraméthylammonium (connu sous les abréviations TMAH et TMAOH).

A la fin de l'étape d, comme illustré à la figure 5, on obtient une pièce de micromécanique formée exclusivement par la couche 5 de géométrie correspondante à l'empreinte 3 présente dans le substrat 1. Avantageusement, la surface externe, c'est-à-dire la surface qui était directement en contact avec le substrat 1, comporte une très bonne rugosité, c'est-à-dire comparable à celle du substrat 1, et est, préférentiellement, utilisée comme surface de contact mécanique. Enfin, pour une hauteur e₃ de la pièce de micromécanique comprise entre 10 µm et 500 µm, seule une épaisseur e₁ de la couche 5 comprise entre 0,2 µm et 20 µm est déposée. On comprend donc immédiatement le gain en coût de matière et en coût de production dû au temps raccourci de l'étape b de dépôt.

Par conséquent, on comprend que l'on peut obtenir une pièce de micromécanique dont la section élémentaire est formée par au moins deux segments sécants et non alignés afin qu'un desdits au moins deux segments forme la hauteur e₃ de la pièce de micromécanique, ladite hauteur e₃ étant supérieure à l'épaisseur e₁ de chaque segment. Bien entendu suivant la complexité de l'empreinte 3, la section élémentaire peut être une section plus simple sensiblement en U, c'est-à-dire comportant trois segments.

Ainsi, suivant la complexité de l'empreinte 3, la pièce de micromécanique est formée par la projection selon une directrice rectiligne ou non (comprenant la révolution) d'au moins une section élémentaire à deux ou trois segments. De plus, il n'est pas plus difficile de former des sections très complexes ou variables comme, par exemple, former une denture sur une paroi de l'empreinte 3 qui formera une denture correspondante pour un des segments de la section.

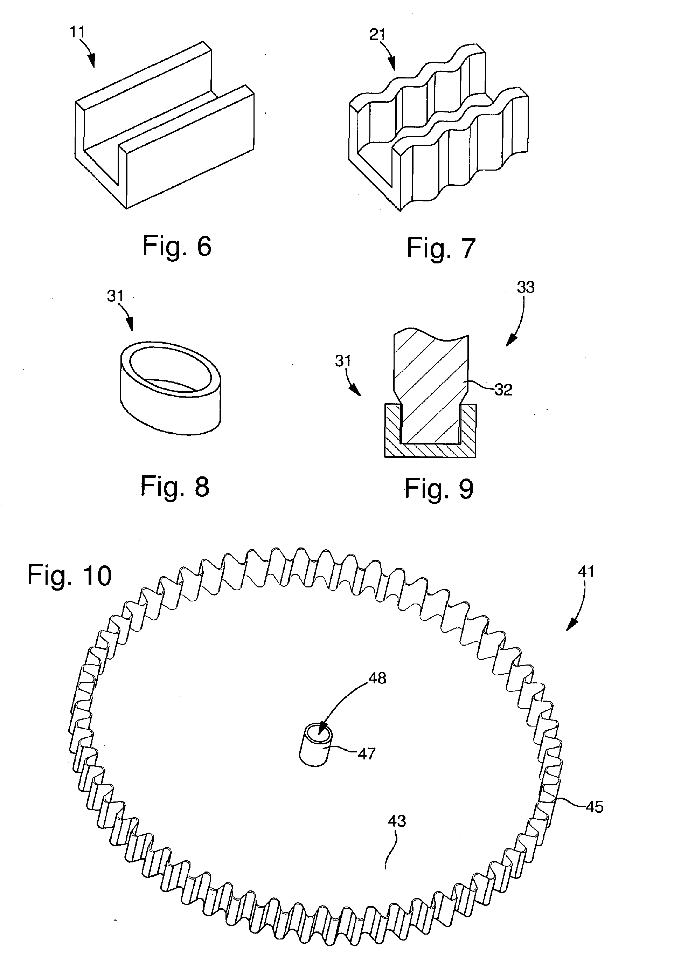

A titre d'exemples nullement limitatifs, des pièces de micromécanique 11, 21, 31, 41 susceptibles d'être obtenues selon le premier mode de réalisation sont présentées aux figures 6 à 10. Ainsi, la figure 6 présente une pièce de micromécanique 11 dont la section élémentaire sensiblement en U est projetée selon une directrice rectiligne. La figure 7 présente une pièce de micromécanique 21 de section élémentaire analogue à celle de la pièce de micromécanique 11 mais qui est projetée selon une directrice sinusoïdale, c'est-à-dire non-rectiligne. On comprend également qu'il est possible de former une pièce de micromécanique qui résulterait d'une moitié de la pièce 11 et de l'autre moitié de la pièce 21 aussi bien transversalement que longitudinalement en une seule pièce sans que le procédé en soit complexifié.

Les figures 8 et 9 présentent un exemple de section élémentaire pouvant être à deux segments qui est projetée en révolution pour obtenir une pièce de micromécanique 31 du type capuchon. Une telle pièce de micromécanique pourrait par exemple être solidarisée sur un élément afin d'améliorer sa tribologie avec un autre organe. A titre d'exemple, la pièce de micromécanique 31 peut être solidarisée à l'extrémité d'un pivot 32 d'un axe 33 afin que le pivot 32 coopère avec un coussinet par l'intermédiaire de la pièce de micromécanique 31.

Enfin, la figure 10 présente un dernier exemple d'une pièce de micromécanique 41 plus complexe sans que le procédé soit plus difficile à mettre en oeuvre. La pièce de micromécanique 41 comporte une planche 43 sensiblement discoïdale à partir de la périphérie de laquelle se projette orthogonalement une denture 45 et dont le centre comporte un canon 47 formant un trou 48 autorisant la coopération par exemple avec un axe de pivotement. A la figure 10, on s'aperçoit donc que l'épaisseur de la denture 45 et du canon 47 sont formées par l'épaisseur e₁ de la couche 5 déposée lors de l'étape b du procédé.

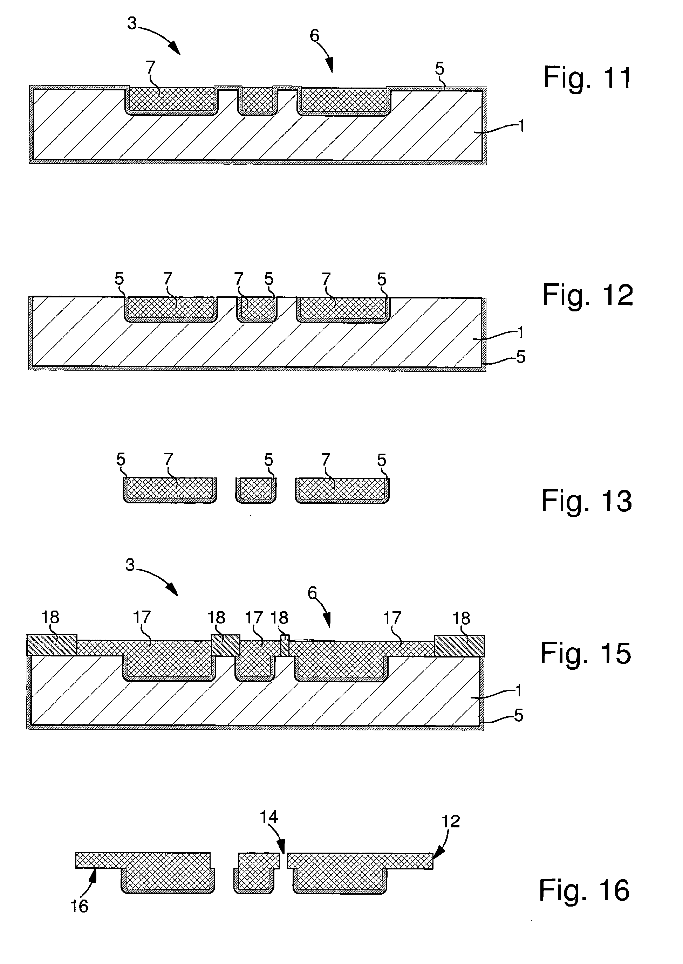

Un deuxième mode de réalisation alternatif au premier expliqué ci-dessus est présenté aux figures 11 à 13. Les étapes a à d restent identiques au premier mode de réalisation. Toutefois, comme illustré à la figure 11, une étape e est réalisée entre l'étape b et l'étape c qui consiste à remplir le creux 6 de l'empreinte 3, revêtue du premier matériau 5, avec un deuxième matériau 7. Ainsi, après les étapes c et d similaires au premier mode de réalisation et illustrées respectivement aux figures 12 et 13, on obtient une pièce de micromécanique en un premier matériau 5 renforcé et/ou décoré par un deuxième matériau 7.

Préférentiellement, le remplissage des creux 6 est effectué par un dépôt galvanique ou une déformation à chaud. Le deuxième matériau est, de manière préférée, un métal ou un alliage métallique qui peut être ou non amorphe. Toutefois, rien n'empêche alternativement de changer le type de dépôt et/ou la nature du matériau déposé.

Par conséquent, lors de la quatrième étape c, non seulement l'épaisseur de ladite couche 5 est circonscrite dans ladite empreinte négative 3 mais le dépôt 7 du deuxième matériau est rendu plan et préférentiellement affleurant à ladite partie circonscrite de la couche 5. Enfin, dans une cinquième et dernière étape d du deuxième mode de réalisation, le procédé consiste à retirer le substrat 1 afin de laisser libre la pièce de micromécanique formée dans l'empreinte 3 avec les mêmes avantages que pour le premier mode de réalisation.

A la fin de l'étape d, comme illustré à la figure 13, on obtient une pièce de micromécanique formée par la couche 5 de géométrie correspondante à l'empreinte 3 présente dans le substrat 1, laquelle est renforcée et/ou décorée avec le dépôt 7. Avantageusement, la surface externe formée par la couche 5, c'est-à-dire la surface qui était directement en contact avec le substrat 1, comporte une très bonne rugosité, c'est-à-dire comparable à celle du substrat 1 et est, préférentiellement, utilisée comme surface de contact.

Selon un autre avantage de l'invention, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon l'invention, il est ainsi possible de former une pièce principalement métallique à partir du dépôt 7 qui est revêtue d'une couche de diamant à partir de la couche 5 alors qu'actuellement, il reste difficile à la connaissance de la Demanderesse de revêtir une pièce métallique avec du diamant.

Enfin, pour une hauteur e₃ de la pièce de micromécanique comprise entre 10 µm et 500 µm, seule une épaisseur e₁ de la couche 5 comprise entre 0,2 µm et 20 µm est déposée, le reste étant comblé par le dépôt 7. On comprend donc immédiatement le gain en coût de matière et en coût de production dû au temps raccourci de l'étape b de dépôt de la couche 5, le reste de la pièce étant formé par un dépôt 7 moins coûteux.

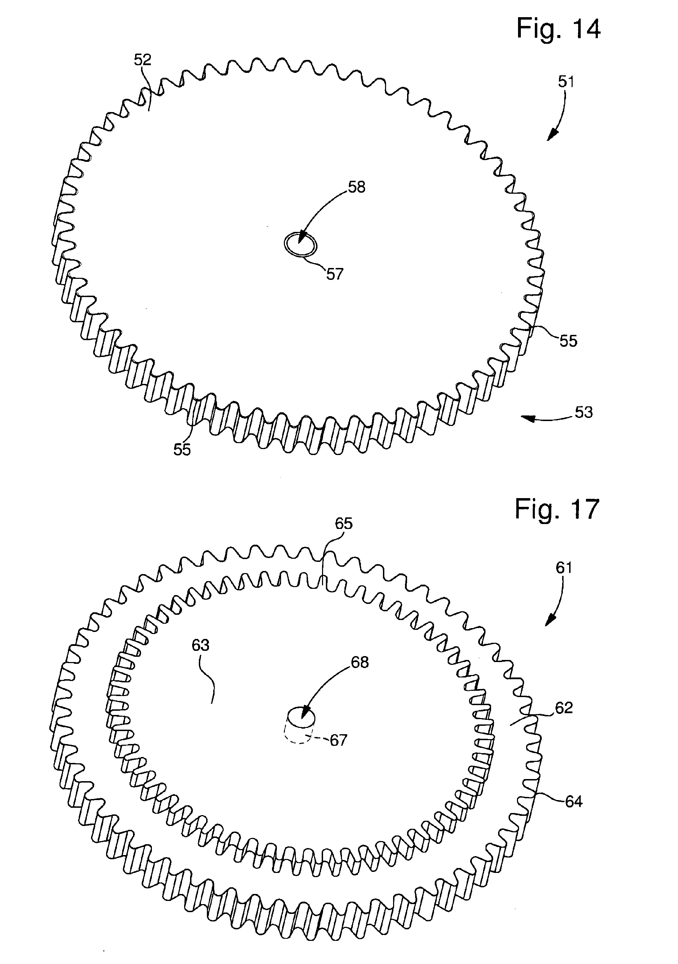

Par conséquent, on comprend que l'on peut obtenir une pièce de micromécanique selon les mêmes sections élémentaires que le premier mode de réalisation. A titre d'exemple nullement limitatif, une pièce de micromécanique 51 susceptible d'être obtenue selon le deuxième mode de réalisation est présentée à la figure 14. La pièce de micromécanique 51 comporte une planche 53 sensiblement discoïdale, comparable à celle 43 de la figure 10, à partir de la périphérie de laquelle se projette orthogonalement une denture 55 et dont le centre comporte un canon 57 formant un trou 58 autorisant la coopération par exemple avec un axe de pivotement. A la figure 14, on s'aperçoit donc que l'épaisseur de la denture 55 et du canon 57 sont formées par l'épaisseur e₁ de la couche 5 déposée lors de l'étape b du procédé, le reste étant comblé par la partie 52 formée par le dépôt 7 de l'étape e.

Un troisième mode de réalisation alternatif au premier expliqué ci-dessus est présenté aux figures 15 et 16. Les étapes a à d restent identiques au premier mode de réalisation. Toutefois, comme illustré à la figure 15, une quatrième étape f est réalisée entre l'étape c et l'étape d qui consiste à remplir le creux 6 de l'empreinte 3, revêtue du premier matériau 5, avec un deuxième matériau 17. Ainsi, après l'étape d similaire au premier mode de réalisation et illustrée à la figure 16, on obtient une pièce de micromécanique en un premier matériau 5 renforcé et/ou décoré par un deuxième matériau 7.

En comparaison de l'étape e du deuxième mode de réalisation, l'étape f est destinée à remplir le creux 6 de l'empreinte 3 et, avantageusement, permet également de former un niveau en saillie de l'épaisseur e₃ afin de former un élément fonctionnel supplémentaire à la pièce de micromécanique comme illustré à la figure 15.

L'étape f comporte de manière préférée une phase de structuration d'un moule 18 sur le substrat 1 après l'étape c. Puis une phase de remplissage de l'évidement formé conjointement par le creux 6 de l'empreinte 3 et les ajourages du moule 18. Enfin, l'étape f comporte une phase de retrait du moule 18 de la surface du substrat 1.

La phase de structuration du moule 18 peut, à titre d'exemple, être formée à l'aide d'une photolithographie d'une résine photosensible du type négatif ou positif. De plus, la phase de remplissage peut, à titre d'exemple, être réalisée à l'aide d'une galvanoplastie. Le deuxième matériau est, de manière préférée, un métal ou un alliage métallique qui peut être ou non amorphe. Toutefois, rien n'empêche alternativement de changer le type de dépôt et/ou la nature du matériau déposé.

L'étape f peut également comporter une ultime phase de rodage et/ou de polissage de la partie supérieure du dépôt 17. Par conséquent, dans une cinquième et dernière étape d du troisième mode de réalisation, le procédé consiste à retirer le substrat 1 afin de laisser libre la pièce de micromécanique formée dans l'empreinte 3 avec les mêmes avantages que pour le premier mode de réalisation.

A la fin de l'étape d, comme illustré à la figure 16, on obtient une pièce de micromécanique formée par la couche 5 de géométrie correspondante à l'empreinte 3 présente dans le substrat 1, laquelle est renforcée et/ou décorée avec le dépôt 17. Avantageusement, la surface externe inférieure est formée par la couche 5, c'est-à-dire la surface qui était directement en contact avec le substrat 1, comporte une très bonne rugosité, c'est-à-dire comparable à celle du substrat 1 et est, préférentiellement, utilisée comme surface de contact.

Selon un autre avantage de l'invention, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon l'invention, il est ainsi possible de former une pièce principalement métallique à partir du dépôt 17 qui est partiellement revêtue d'une couche de diamant à partir de la couche 5 alors qu'actuellement, il reste difficile à la connaissance de la Demanderesse de revêtir une pièce métallique avec du diamant.

De plus, dans le troisième mode de réalisation, la pièce de micromécanique comporte également un deuxième niveau supérieur entièrement formé par le dépôt 17, c'est-à-dire sans couche 5, afin de former un élément fonctionnel supplémentaire à la pièce de micromécanique. Cet élément fonctionnel peut, à titre non limitatif, être une denture 12, un trou 14 et/ou une portée 16 destinés, par exemple, à coopérer avec un autre organe.

Comme pour les deux premiers modes de réalisation, on comprend donc immédiatement le gain en coût de matière et en coût de production dû au temps raccourci de l'étape de dépôt de la couche 5, le reste de la pièce étant formé par un dépôt 17 moins coûteux tout en offrant une géométrie qui peut être très complexe.

Par conséquent, on comprend que l'on peut obtenir une pièce de micromécanique selon les mêmes sections élémentaires que les deux premiers modes de réalisation. A titre d'exemple nullement limitatif, une pièce de micromécanique 61 susceptible d'être obtenue selon le troisième mode de réalisation est présentée à la figure 17. La pièce de micromécanique 61 comporte une planche 63 sensiblement discoïdale, comparable à celle 43 de la figure 10, à partir de la périphérie de laquelle se projette orthogonalement une denture 65 et dont le centre comporte un canon 67 formant un trou 68, le reste étant comblé par le dépôt 17 lors de l'étape f. Sur un second niveau uniquement formé par le dépôt 17, la pièce de micromécanique 61 comporte une roue 62 dont la périphérie comporte une denture 64 et dont le centre comporte un trou de section préférentiellement plus faible que le trou 68 destiné, par exemple, à coopérer avec un axe de pivotement.

Bien entendu, la présente invention ne se limite pas à l'exemple illustré mais est susceptible de diverses variantes et modifications qui apparaîtront à l'homme de l'art. En particulier, plusieurs pièces de micromécanique de motif identique ou non peuvent être fabriquées en même temps sur un même substrat. De plus, dans l'exemple de la figure 4 ou de la figure 12, on s'aperçoit que le retrait du substrat 1 forme également une pièce de section sensiblement en U formée par la couche 5 sur la périphérie et la partie inférieure du substrat 1.

Par conséquent, non seulement plusieurs empreintes 3 identiques ou non peuvent être formées sur le substrat 1 mais elles peuvent l'être également sur plusieurs faces du substrat 1, c'est-à-dire que les étapes a et c, et, éventuellement, e ou f, peuvent être appliquées à plusieurs faces du substrat 1. Dans le cas des deuxième et troisième modes de réalisation, il est ainsi envisageable d'obtenir une pièce monobloc formée par la couche 5 sur la périphérie et/ou la partie inférieure du substrat 1 et une pièce renforcée et/ou décorée formée par la couche 5 et le dépôt 7, 17 sur la partie supérieure du substrat 1.

De plus, les modes de réalisation sont combinables entre eux. Ainsi à titre d'exemple non limitatif, la pièce 51 peut être obtenue à l'aide du troisième mode de réalisation modifié. En effet, les étapes a à c pourraient être mise en oeuvre suivi d'une étape f dont le dépôt 17 serait similaire au dépôt 7 du deuxième mode de réalisation, c'est-à-dire ne faisant pas saillie de l'empreinte 3. On comprend donc que l'étape f modifiée du troisième mode de réalisation serait similaire à l'étape e du deuxième mode de réalisation mais en étant effectuée après l'étape c et non après l'étape b.

Enfin, même si les segments sont présentés sensiblement perpendiculaires sur les figures, il est bien évident que l'angle qu'ils forment l'un par rapport à l'autre peut également être aigu ou obtus.

## Revendications

1. Procédé de fabrication d'une pièce de micromécanique (11, 21, 31, 41, 51, 61) en un matériau monobloc à base d'un allotrope synthétique du carbone **caractérisé en ce qu'**il comporte les étapes suivantes :
a) former un substrat (1) comportant l'empreinte (3) négative de ladite pièce de micromécanique à fabriquer ;
b) recouvrir ladite empreinte négative du substrat (1) directement d'une couche (5) dudit matériau à base d'un allotrope synthétique du carbone d'une épaisseur (e₁) inférieure à la profondeur de ladite empreinte (3) ;
c) retirer du substrat (1) une épaisseur supérieure (e₂) à celle (e₁) de la couche déposée (5) afin de laisser une épaisseur de ladite couche circonscrite dans ladite empreinte négative ;
d) retirer le substrat (1) afin de laisser libre la pièce de micromécanique (11, 21, 31, 41, 51, 61) monobloc formée dans ladite empreinte négative et comportant une surface externe de rugosité comparable à celle du substrat (1).

2. Procédé selon la revendication précédente, **caractérisé en ce que** l'empreinte (3) négative comporte une paroi formant une denture (45, 55, 65).

3. Procédé selon la revendication 1 ou 2, **caractérisée en ce que** le matériau (5) à base d'un allotrope synthétique du carbone est sous forme cristallisée.

4. Procédé selon la revendication 1 ou 2, **caractérisée en ce que** le matériau (5) à base d'un allotrope synthétique du carbone est sous forme amorphe.

5. Procédé selon l'une des revendications précédentes, **caractérisé en ce qu'**il comporte, entre l'étape b) et l'étape c), l'étape suivante :
e) remplir l'empreinte (3) revêtue du matériau (5) à base d'un allotrope synthétique du carbone avec un deuxième matériau (7) afin qu'après les étapes c) et d), on obtienne une pièce de micromécanique (51) en un matériau (5) à base d'un allotrope synthétique du carbone renforcé et/ou décoré par un deuxième matériau (7).

6. Procédé selon l'une des revendications 1 à 4, **caractérisé en ce qu'**il comporte, entre l'étape c) et l'étape d), l'étape suivante :
f) remplir l'empreinte (3) revêtue du matériau (5) à base d'un allotrope synthétique du carbone avec un deuxième matériau (7, 17) afin qu'après l'étape d), on obtienne une pièce de micromécanique (51, 61) en un matériau (5) à base d'un allotrope synthétique du carbone renforcé et/ou décoré par un deuxième matériau (7, 17).

7. Procédé selon la revendication précédente, **caractérisé en ce que**, lors de l'étape f), le deuxième matériau (17) est formé en saillie de ladite empreinte afin de former un élément fonctionnel (12, 14, 16, 62) supplémentaire à la pièce de micromécanique.

8. Procédé selon l'une des revendications 5 à 7, **caractérisé en ce que** le deuxième matériau (7, 17) comporte un métal ou un alliage métallique.

9. Procédé selon l'une des revendications précédentes, **caractérisé en ce que** la pièce de micromécanique forme une partie de l'habillage, d'un spiral, d'un balancier, d'une ancre, d'un pont, d'un mobile ou d'une roue d'échappement d'une pièce d'horlogerie.

10. Pièce de micromécanique creuse (11, 21, 31, 41, 51, 61) obtenue à partir du procédé selon l'une des revendications précédentes, ladite pièce étant formée de manière monobloc en matériau à base d'un allotrope synthétique du carbone selon une couche (5) d'épaisseur (e₁) comprise entre 0,2 µm et 20 µm, ladite pièce comportant une surface externe dont la hauteur (e₃) est supérieure à l'épaisseur (e₁) de la couche (5) en matériau à base d'un allotrope synthétique du carbone, ladite surface externe comportant une hauteur (e₃) comprise entre 10 µm et 500 µm et dont la rugosité comprend un écart moyen arithmétique (Rₐ) sensiblement inférieur à 10 nm.

11. Pièce selon la revendication précédente, **caractérisée en ce que** ladite surface externe forme une denture (45, 55, 65).

12. Pièce selon la revendication 10 ou 11, **caractérisée en ce que** le creux de la pièce en matériau à base d'un allotrope synthétique du carbone est au moins partiellement rempli avec un deuxième matériau (7, 17) afin d'obtenir une pièce de micromécanique (51, 61) à base d'un allotrope synthétique du carbone renforcé et/ou décoré par un deuxième matériau (7, 17).

13. Pièce selon la revendication précédente, **caractérisée en ce que** ledit deuxième matériau est formé en saillie de ladite hauteur (e₃) de la surface externe afin de former un élément fonctionnel (12, 14, 16, 62) supplémentaire à la pièce de micromécanique.

14. Pièce selon l'une des revendications 11 à 13, **caractérisée en ce que** le deuxième matériau (7, 17) comporte un métal ou un alliage métallique.

15. Pièce d'horlogerie **caractérisée en ce qu'**elle comporte une pièce de micromécanique (11, 21, 31, 41, 51, 61) selon l'une des revendications 10 à 14.

16. Pièce d'horlogerie selon la revendication précédente, **caractérisée en ce que** ladite pièce de micromécanique forme tout ou partie de l'habillage, d'un spiral, d'un balancier, d'une ancre, d'un pont, d'un mobile ou d'une roue d'échappement.

## Patentansprüche

1. Verfahren zum Herstellen eines Mikromechanik-Stücks (11, 21, 31, 41, 51, 61) aus einem Monoblockwerkstoff auf Basis eines synthetischen Kohlenstoff-Allotropen, **dadurch gekennzeichnet, dass** es folgende Schritte umfasst:
a) Ausbilden eines Substrats (1), das die negative Abformung (3) des herzustellenden Mikromechanik-Stücks umfasst;
b) direktes Überdecken der negativen Abformung des Substrats (1) mit einer Schicht (5) des Werkstoffs auf Basis eines synthetischen Kohlenstoff-Allotropen von einer Dicke (e₁), die geringer ist als die Tiefe der Abformung (3);
c) Entfernen vom Substrat (1) einer Dicke (e₂), die grösser ist als diejenige (e₁) der aufgebrachten Schicht (5), um eine Dicke der in der negativen Abformung umgrenzten Schicht zu lassen;
d) Entfernen des Substrats (1), um das Monoblock-Mikromechanik-Stück (11, 21, 31, 41, 51, 61), das in der negativen Abformung ausgebildet ist und eine Aussenfläche von einer Rauheit umfasst, die mit derjenigen des Substrats (1) vergleichbar ist, frei zu lassen.

2. Verfahren nach vorhergehendem Anspruch, **dadurch gekennzeichnet, dass** die negative Abformung (3) eine Wandung umfasst, die eine Zahnung (45, 55, 65) bildet.

3. Verfahren nach Anspruch 1 oder 2, **dadurch gekennzeichnet, dass** der Werkstoff (5) auf Basis eines synthetischen Kohlenstoff-Allotropen in kristallisierter Form ist.

4. Verfahren nach Anspruch 1 oder 2, **dadurch gekennzeichnet, dass** der Werkstoff (5) auf Basis eines synthetischen Kohlenstoff-Allotropen in amorpher Form ist.

5. Verfahren nach einem der vorhergehenden Ansprüche, **dadurch gekennzeichnet, dass** es zwischen dem Schritt b) und dem Schritt c) folgenden Schritt umfasst:
e) Füllen der mit dem Werkstoff (5) auf Basis eines synthetischen Kohlenstoff-Allotropen überdeckten Abformung (3) mit einem zweiten Werkstoff (7), damit man nach den Schritten c) und d) ein Mikromechanik-Stück (51) aus einem Werkstoff (5) auf Basis eines synthetischen Kohlenstoff-Allotropen erhält, der durch einen zweiten Werkstoff (7) verstärkt und/oder dekoriert ist.

6. Verfahren nach einem der Ansprüche 1 bis 4, **dadurch gekennzeichnet, dass** es zwischen dem Schritt c) und dem Schritt d) folgenden Schritt umfasst:
f) Füllen der mit dem Werkstoff (5) auf Basis eines synthetischen Kohlenstoff-Allotropen überdeckten Abformung (3) mit einem zweiten Werkstoff (7, 17), damit man nach dem Schritt d) ein Mikromechanik-Stück (51, 61) aus einem Werkstoff (5) auf Basis eines synthetischen Kohlenstoff-Allotropen erhält, der durch einen zweiten Werkstoff (7, 17) verstärkt und/oder dekoriert ist.

7. Verfahren nach vorhergehendem Anspruch, **dadurch gekennzeichnet, dass** der zweite Werkstoff (17) während des Schritts f) aus der Abformung vorspringend ausgebildet wird, um ein das Mikromechanik-Stück ergänzendes funktionelles Element (12, 14, 16, 62) zu bilden.

8. Verfahren nach einem der Ansprüche 5 bis 7, **dadurch gekennzeichnet, dass** der zweite Werkstoff (7, 17) ein Metall oder eine Metall-Legierung umfasst.

9. Verfahren nach einem der vorhergehenden Ansprüche, **dadurch gekennzeichnet, dass** das Mikromechanik-Stück einen Teil der Ummantelung, einer Spiralfeder, einer Unruh, eines Ankers, einer Brücke, eines Drehteils oder eines Hemmungsrads eines Zeitmessgeräts bildet.

10. Hohles Mikromechanik-Stück (11, 21, 31, 41, 51, 61), das ausgehend vom Verfahren gemäss einem der vorhergehenden Ansprüche erhalten wird, wobei das Stück monoblockartig aus einem Werkstoff auf Basis eines synthetischen Kohlenstoff-Allotropen gemäss einer Schicht (5) von einer Dicke (e₁), die zwischen 0,2 µm und 20 µm liegt, ausgebildet ist, wobei das Stück eine Aussenfläche umfasst, deren Höhe (e₃) grösser ist als die Dicke (e₁) der Schicht (5) aus einem Werkstoff auf Basis eines synthetischen Kohlenstoff-Allotropen, wobei die Aussenfläche eine Höhe (e₃) aufweist, die zwischen 10 µm und 500 µm liegt, und wobei die Rauheit dieser Aussenfläche eine arithmetische Durchschnittsabweichung (Rₐ) aufweist, die merklich kleiner ist als 10 nm.

11. Stück nach vorhergehendem Anspruch, **dadurch gekennzeichnet, dass** die Aussenfläche eine Zahnung (45, 55, 65) bildet.

12. Stück nach Anspruch 10 oder 11, **dadurch gekennzeichnet, dass** der Hohlraum des Stücks aus einem Werkstoff auf Basis eines synthetischen Kohlenstoff-Allotropen wenigstens teilweise mit einem zweiten Werkstoff (7, 17) gefüllt wird, um ein Mikromechanik-Stück (51, 61) auf Basis eines synthetischen Kohlenstoff-Allotropen zu erhalten, der durch einen zweiten Werkstoff (7, 17) verstärkt und/oder dekoriert ist.

13. Stück nach vorhergehendem Anspruch, **dadurch gekennzeichnet, dass** der zweite Werkstoff über die Höhe (e₃) der Aussenfläche herausragend ausgebildet wird, um ein das Mikromechanik-Stück ergänzendes funktionelles Element (12, 14, 16, 62) zu bilden.

14. Stück nach einem der Ansprüche 11 bis 13, **dadurch gekennzeichnet, dass** der zweite Werkstoff (7, 17) ein Metall oder eine Metall-Legierung umfasst.

15. Zeitmessgerät, **dadurch gekennzeichnet, dass** es ein Mikromechanik-Stück (11, 21, 31, 41, 51, 61) gemäss einem der Ansprüche 10 bis 14 umfasst.

16. Zeitmessgerät nach vorhergehendem Anspruch, **dadurch gekennzeichnet, dass** das Mikromechanik-Stück die Gesamtheit oder einen Teil der Ummantelung, einer Spiralfeder, einer Unruh, eines Ankers, einer Brücke, eines Drehteils oder eines Hemmungsrads bildet.

## Claims

1. Method of fabricating a micromechanical part (11, 21, 31, 41, 51, 61) in a single-piece made of a synthetic carbon allotrope, **characterized in that** it includes the following steps:
a) forming a substrate (1) which includes the negative cavity (3) for the micromechanical part to be fabricated;
b) coating the negative cavity (3) of the substrate (1) with a layer (5) of the synthetic carbon allotrope, the thickness (e₁) of which is less than the depth of the negative cavity (3);
c) removing from the substrate (1) a larger thickness (e₂) than the thickness (e₁) of the deposited layer (5), so as to leave a limited thickness of the layer of material in the negative cavity (3);
d) removing the substrate (1) so as to release the single-piece micromechanical part (11, 21, 31, 41, 51, 61) formed in the negative cavity (3) comprising an external surface of comparable roughness to that of the substrate (1).

2. Method according to the preceding claim, **characterized in that** the negative cavity (3) includes a wall forming a toothing (45, 55, 65).

3. Method according to claim 1 or 2, **characterized in that** the synthetic carbon allotrope (5) is in crystallised form.

4. Method according to claim 1 or 2, **characterized in that** the synthetic carbon allotrope (5) is in amorphous form.

5. Method according to any of the preceding claims, **characterized in that** between step b) and step c), it includes the following step:
e) filling the cavity (3) coated with the synthetic carbon allotrope (5) with a second material (7) so that, after steps c) and d), there is obtained a micromechanical part (51) in a synthetic carbon allotrope (5) reinforced and/or decorated with a second material (7).

6. Method according to any of claims 1 to 4, **characterized in that** between step c) and step d), it includes the following step:
f) filling the cavity (3) coated with the synthetic carbon allotrope (5) with a second material (7, 17) so that, after step d), there is obtained a micromechanical part (51, 61) made of a synthetic carbon allotrope (5) reinforced and/or decorated with a second material (7, 17).

7. Method according to the preceding claim, **characterized in that**, in step f), the second material (17) is formed protruding from the negative cavity (3) in order to form an additional functional element (12, 14, 16, 62) of the micromechanical part.

8. Method according to any of claims 5 to 7, **characterized in that** the second material (7, 17) includes a metal or metal alloy.

9. Method according to any of the preceding claims, **characterized in that** the micromechanical part forms an exterior part, balance spring, balance, pallet lever, bridge, wheel set or escape wheel of a timepiece.

10. Hollow micromechanical part (11, 21, 31, 41, 51, 61) produced by the method according to any of the preceding claims, the micromechanical part being formed in a single-piece made of a synthetic carbon allotrope in a layer (5) with a thickness (e₁) of between 0.2 µm and 20 µm, the micromechanical part comprising an external surface having a height (e₃) higher than the thickness (e₁) of the layer (5) made of synthetic carbon allotrope, the external surface comprising a height (e₃) of between 10 µm and 500 µm and whose roughness has an arithmetic mean deviation (Ra) substantially lower than 10 nm.

11. Part according to the preceding claim, **characterized in that** the external surface forms a toothing (45, 55, 65).

12. Part according to claim 10 or 11, **characterized in that** the hollow of the synthetic carbon allotrope-based micromechanical part is at least partially filled with a second material (7, 17) so as to produce a synthetic carbon allotrope-based micromechanical part (51, 61) which is reinforced and/or decorated with a second material (7, 17).

13. Part according to the preceding claim, **characterized in that** the second material is formed protruding from the height (e₃) of the external surface in order to form an additional functional element (12, 14, 16, 62) of the micromechanical part.

14. Part according to any of claims 11 to 13, **characterized in that** the second material (7, 17) includes a metal or metal alloy.

15. Timepiece **characterized in that** it includes a micromechanical part (11, 21, 31, 41, 51, 61) according to any of claims 10 to 14.

16. Timepiece according to the preceding claim, **characterized in that** the micromechanical part forms all or part of the exterior parts, balance spring, balance, pallet lever, bridge, wheel set or escape wheel.
